# EUROPÄISCHE PATENTSCHRIFT

(11) **EP 0 754 303 B1**
(45) Veröffentlichungstag und Bekanntmachung des Hinweises auf die Patenterteilung: **17.12.1997**
(21) Anmeldenummer: 95939225.9
(22) Anmeldetag: 06.12.1995
(51) Int. Cl.: G01R 19/165

(54) **SICHERE SPANNUNGSÜBERWACHUNG**
RELIABLE VOLTAGE MONITORING SYSTEM
SYSTEME DE CONTROLE FIABLE DE LA TENSION

(30) Priorität: 09.12.1994 DE 4443862
(43) Veröffentlichungstag der Anmeldung: 22.01.1997
(73) Patentinhaber: PILZ GmbH & CO., 73760 Ostfildern (DE)
(72) Erfinder: SCHWENKEL, Hans, Dieter, D-70192 Stuttgart (DE); WEISHAAR, Christoph, D-71332 Waiblingen (DE)
(74) Vertreter: Patentanwälte Rüger, Barthelt & Abel
(86) Internationale Anmeldenummer: DE9501730
(87) Internationale Veröffentlichungsnummer: WO9618107

(56) Entgegenhaltungen:
- EP-A- 0 286 282

## Beschreibung

Je stärker in modernen Anlagen die einzelnen Prozesse automatisiert werden, umso größer ist das Bestreben, diese Prozesse so sicher wie nur denkbar auszulegen. Die Sicherheit darf nicht durch Störungen einzelner Bauelement beeinträchtigt werden, bzw. wenn solche Bauelementeausfälle auftreten, müssen sie erkannt werden, noch ehe es zu gefährlichen Situationen kommen kann.

Eine kritische Stelle ist dabei die Versorgungsspannung der elektronischen Steuerungen, aie zur Prozeßleitung und -überwachung verwendet werden. Derartige Steuerungen sind heute üblicherweise Digitalsteuerungen, die die Eigenschaft haben, nur in einem verhältnismäßig kleinen Versorgungsspannungsbereich ihrer Spezifikationen gemäß zu arbeiten. Wenn die Versorgungsspannung zu hoch wird, drohen die Bauelemente wegen Spannungsüberschreitung oder zu großer Verlustwärme auszufallen. Diese Schäden sind irreversibel und haben einen größeren Reparaturaufwand zur Folge.

Sinkt hingegen die Versorgungsspannung unter kritische Werte, vermindert sich der Störabstand in der Schaltung, d.h. die Schaltschwellen können durch äußere Störsignale zufällig über- oder unterschritten werden, was wiederum zu Steuerungsfehlern führt. Außerdem kann bei zu kleiner Versorgungsspannung die Signalunterscheidung unsicher werden. Eine unsichere Unterscheidung würde zu einer Verwechslung zwischen den beiden Digitalsignalen null und eins führen.

Um eine Spannung daraufhin zu überprüfen, ob sie innerhalb eines vorgegebenen Toleranzfensters liegt, werden beispielsweise Fensterdiskriminatoren verwendet. Bei dieser Form des Vergleichs wird eine von der Versorgungsspannung im wesentlichen unabhängige Referenzspannung in einen Eingang des Diskriminators eingespeist. Die damit zu vergleichende Spannung wird, wenn sie nicht ohnehin als Gleichspannung vorliegt, gleichgerichtet und sodann dem anderen Eingang des Diskriminators zugeführt. Das Ausgangssignal des Diskriminators ist von dem Vergleich abhängig und nimmt beispielsweise den Wert eins an, wenn das überwachte Signal im Toleranzfenster liegt und wechselt auf den Zustand null, sobald das überwachte Signal aus dem Toleranzfenster herauskommt.

Eine derartige Schaltung ist allerdings nicht hinreichend sicher, denn Fehler im Diskriminator selbst können zu einer konstanten Spannung am dessen Ausgang führen, die einen der beiden möglichen Vergleichszustände simuliert.

Ausgehend hiervon ist es Aufgabe der Erfindung, eine Vorrichtung zu schaffen, um zwei Spannungen miteinander zu vergleichen, wobei das Ausgangssignal der Vorrichtung ein sehr hohes Maß an Zuverlässigkeit hat.

Bei der neuen Vorrichtung werden die beiden Gleichspannungen nicht unmittelbar mit Hilfe eines Komparators verglichen, sondern eine der beiden zu vergleichenden Spannungen gelangt in eine Spannungkonvertierungseinrichtung, die aus der zugeführten Gleichspannung eine Spannung macht, der eine Wechselspannung überlagert ist. Das am Ausgang der Spannungkonvertierungseinrichtung anstehende Signal ist somit ein Gleichspannungssignal mit Wechselkomponente oder, anders ausgedrückt, ein Wechselspannungssignal, das im Gleichspannungspegel verschoben ist. Das Signal am Ausgang der Spannungkonvertierungseinrichtung schwankt deswegen periodisch zwischen einem oberen Amplitudenwert und einem unteren Amplitudenwert hin und her, wobei der Abstand zwischen dem beiden Amplitudenwerten ein vorgegebener Differenzwert ist. Dieser Differenzwert kann gleich dem Fenster gemacht werden, innerhalb dem sich die eine der zu überwachenden Spannungen bewegen soll.

Das so modifizierte Signal gelangt in den anderen Eingang des Komparators, der dann und nur dann an seinem Ausgang ein Wechselsignal abgibt, wenn das eingespeiste Wechselsignal periodische größer und kleiner wird als das an dem anderen Eingang eingespeiste Dauersignal. Wird die beispielsweise die der Spannungkonvertierungseinrichtung zugeführte Gleichspannung zu groß, dann steigt bei der entsprechenden Bemessung der untere Amplitudenwert auf einen Wert größer als die Vergleichsspannung, womit der Komparator am Ausgang ein Dauerstrichsignal abgibt. Gleiches gilt, wenn die der Spannungkonvertierungseinrichtung zugeführte Spannung zu klein wird, weil dann deren Ausgangssignal nicht mehr größer werden kann als das andere in den Komparator eingespeiste Signal. Somit ist das Auftreten eines Wechselsignals am Ausgang des Komparators ein sicheres Zeichen dafür, daß die beiden miteinander zu vergleichenden Spannungen unter Berücksichtigung einer festgelegten Toleranzbreite gleich sind.

Sollten innerhalb der Überwachungsschaltung Bauelemente versagen, kann dies allenfalls dazu führen, daß der Komparator an seinem Ausgang ein Dauerstrichsignal abgibt und das Wechselsignal ausbleibt. Ein Versagen von Bauelementen kann praktisch niemals zu einem Wechselsignal am Ausgang des Komparators führen, weshalb die neue Vorrichtung eine sehr hohe Sicherheit gewährleistet.

Die Spannungkonvertierungseinrichtung wirkt sozusagen wie eine Summierschaltung, bei der der zu überwachenden Spannung ein Wechselsignal hinzuaddiert wird, dessen halber Scheitel-Scheitel-Wert betragsmäßig kleiner ist als die zugeführte Spannung. Der Scheitel-Scheitel-Wert entspricht sozusagen dem Toleranzfenster, in den der Spannungswert hineinfallen soll.

Bei der neuen Vorrichtung ist es gleichgültig, ob die Referenzspannung dem Komparator unmittelbar und die überwachte Spannung in die Spannungkonvertierungseinrichtung eingespeist wird oder ob die beiden Spannungen miteinander vertauscht sind.

Je nachdem, ob der Sollwert symmetrisch in dem Toleranzfenster liegt oder nach einer Seite hin verschoben ist, kann der Durchschnittswert der Ausgangsspannung durch die Überlagerung eines Korrekturgliedes entsprechend verschoben werden.

Wenn es darum geht, mit der neuen Vorrichtung eine Versorgungsspannung zu überwachen, kann aus der Versorgungsspannung eine Spannung erzeugt werden, deren Größe und Änderung der Versorgungsspannung proportional ist oder es kann eine abgeleitete Spannung erzeugt werden, die um einen konstanten Term kleiner als die Versorgungsspannung ist, wobei aber die Änderungen der abgeleiteten Spannung betragsmäßig gleich groß sind wie die Änderungen der Versorgungsspannung. Eine solche Spannung läßt sich beispielsweise mit Hilfe eines Widerstands und einer Z-Diode erzeugen, wobei die abgeleitete Spannung am Widerstand abgegriffen wird und die Versorgungsspannung an der Serienschaltung aus dem Widerstand und der Z-Diode liegt. Eine derartige Schaltung hat den Vorteil einer sehr großen Empfindlichkeit, weil die Änderungen der Versorgungsspannung nicht mit heruntergeteilt werden.

Wenn die oben erwähnte Schaltung umgekehrt wird, d.h. die Ausgangsspannung an der Z-Diode abgegriffen wird, läßt sich auf diese Weise einfach aus der Versorgungsspannung eine Referenzspannung ableiten, die von der Versorgungsspannung weitgehend unabhängig ist, vorausgesetzt die Versorgungsspannung ist größer als die Durchlaßspannung der Z-Diode.

Bei entsprechender schaltungstechnischer Auslegung der Signalumformereinrichtung läßt sich diese gleichzeitig zur Gewinnung der Referenzspannung heranziehen, beispielsweise indem sie zwischen ihrem Ausgang und einer mit dem Komparator gemeinsamen Schaltungsmasse eine oder mehrere Bauelemente mit Z-Dioden-Charakteristik enthält. Durch periodisches Ein- und Ausschalten eines damit in Serie liegenden und einen Spannungsabfall erzeugenden Elements läßt sich die erforderliche Ausgangsspannung erzielen.

Wenn die Versorgungsspannung über ein Element mit Z-Dioden-Charakteristik an den Ausgang der Signalumformereinrichtung gelangt, und dieser über eine Widerstandsdiodenkombination nach Masse geschaltet ist, wird die gewünschte pulsierende Gleichspannung erzielt, indem zu den nach Masse geschalteten Elementen ein elektronischer Schalter parallelliegt, der durch das Rechtecksignal periodisch ein- und ausgeschaltet wird.

In beiden Fällen können Digitalschaltungen mit sogenanntem Openkollektorausgang eingesetzt werden.

Es ist jedoch auch möglich, mit Hilfe der Komplementärendstufe, wie sie in vielen Digitalschaltungen vorhanden ist, das gewünschte Signal zu erzeugen. In diesem Falle wird über die Endstufe der Digitalschaltung und einen zusätzlichen Widerstand periodisch eine kleine Spannungskomponente zu dem Ausgangssignal hinzuaddiert. An den Addierer werden dabei keine besonderen Anforderungen gestellt, d.h. es genügt eine einfache Zusammenschaltung über Widerstände.

Um die Signalerkennung für die nachfolgende Schaltung, die das Vergleichssignal verwertet, besonders sicher zu machen, ist an den Ausgang des Komparators ein Spannungswandler angeschlossen, der eine systemfremde Spannung erzeugt. Unter "systemfremd" wird hierbei eine Spannung verstanden, die aus der normalen Versorgungsspannung, die mit Hilfe der neuen Vorrichtung überwacht wird, nicht dadurch hergeleitet werden kann, daß in der Versorgungsspannung Kurzschlüsse auftreten. Die sogenannte "systemfremde" Spannung ist folglich eine Spannung, die unter Berücksichtigung von Vorzeichen und Betrag größer als die maximal zulässige Versorgungsspannung oder kleiner als die kleinste im Fehlerfall auftretenden Versorgungsspannung ist, beispielsweise bei bipolarer Stromversorgung. Eine andere Möglichkeit für eine systemfremde Spannung ist eine galvanisch getrennte Spannung. Die nach Betrag und Vorzeichen größere bzw. kleinere Spannung läßt sich sehr einfach mit einer Vervielfacherschaltung ähnlich einer Villardschaltung erzeugen, während die galvanisch getrennte Spannung unter Zuhilfenahme eines Transformators erzeugt wird. Der Transformator kann unmittelbar an den Ausgang des Transformators angeschlossen werden oder über einen aktiven Zwischenkreis, falls die Ausgangsleistung des Komparators zur Ansteuerung des Transformators nicht ausreicht.

Schließlich ist es von Vorteil, gegebenenfalls auch die Taktfrequenz mit in die Überwachung einzubeziehen, um auch insoweit noch Sicherheit zu gewinnen. Diese Frequenzüberwachung geschieht im einfachsten Falle mit Hilfe eines Serienschwingkreises, der obendrein den Vorteil hat, besonders sicher zu sein.

Im übrigen sind Weiterbildungen der Erfindung Gegenstand von Unteransprüchen.

In der Zeichnung sind Ausführungsbeispiele des Gegenstandes der Erfindung dargestellt. Es zeigen:
Fig. 1 die Vorrichtung zum Vergleichen zweier Gleichspannungen in einem Blockschaltbild,
Fig. 2 bis Fig. 5 die zeitlichen Verläufe verschiedener Spannungen an verschiedenen Stellen der Vorrichtung nach Fig. 1,
Fig. 6 ein Ausführungsbeispiel der Vorrichtung nach Fig. 1 unter Veranschaulichung weiterer Einzelheiten,
Fig. 7 ein weiteres Ausführungsbeispiel der Vorrichtung nach Fig. 1, ebenfalls unter Veranschaulichung weiterer Schaltungseinzelheiten,
Fig. 8 ein Ausführungsbeispiel für den Spannungswandler der Vorrichtung nach Fig. 1,
Fig. 9 ein weiteres Ausführungsbeispiel für den Spannungswandler der Vorrichtung nach Fig. 1 und
Fig. 10 ein Prinzipschaltbild eines Frequenzdetektors.

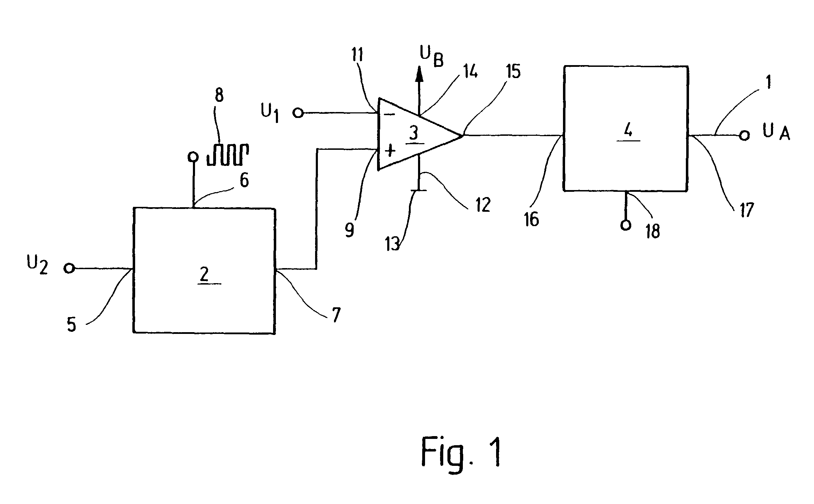

Fig. 1 zeigt eine Vorrichtung, die dazu vorgesehen ist, eine erste Gleichspannung U₁ mit einer zweiten Spannung U₂ zu vergleichen und an einem Ausgang 1 eine systemfremde Spannung U_{A} an einem Ausgang 1 abzugeben, wenn die beiden Gleichspannungen U₁ und U₂ unter Berücksichtigung einer zulässigen Toleranzbreite gleich groß sind.

Die Vorrichtung 1 enthält als wesentliche Schaltungsblöcke eine Spannungskonvertierungsschaltung 2, einen Spannungskomparator 3 sowie einen Spannungswandler 4. Die Spannungskonvertierungsschaltung 2 weist einen Signaleingang 5, einen Steuereingang 6 sowie einen Ausgang 7 auf. In den Steuereingang 6 wird eine Rechteckspannung 8 eingespeist, die von einem nicht weiter veranschaulichten Rechteckgenerator geliefert wird. Der Ausgang 7 der Spannungskonvertierungsschaltung 2 ist an einen nichtinvertierenden Eingang 9 des Komparators 3 angeschlossen, dessen invertierender Eingang 11 mit der ersten Gleichspannung U₁ beaufschlagt ist. Die zweite mit der Spannung U₁ zu vergleichende Spannung U₂ gelangt in den Eingang 5 der Spannungskonvertierungsschaltung 2.

Der Spannungskomparator 3 ist mit einem Anschluß 12 mit einer gemeinsamen Schaltungsmasse 13 verbunden, während er an einem Anschluß 14 seine Versorgungsspannung U_{B} aus einer gemeinsamen Spannungsquelle erhält. Sein Ausgang 15 ist mit einem Eingang 16 des Spannungswandlers 4 verbunden, dessen Ausgang 17 gleichzeitig auch den Ausgang 1 der gesamten Vorrichtung darstellt. Gegebenenfalls kann der Spannungswandler 4 noch mit einem Enable- oder Freigabeeingang 18 versehen sein.

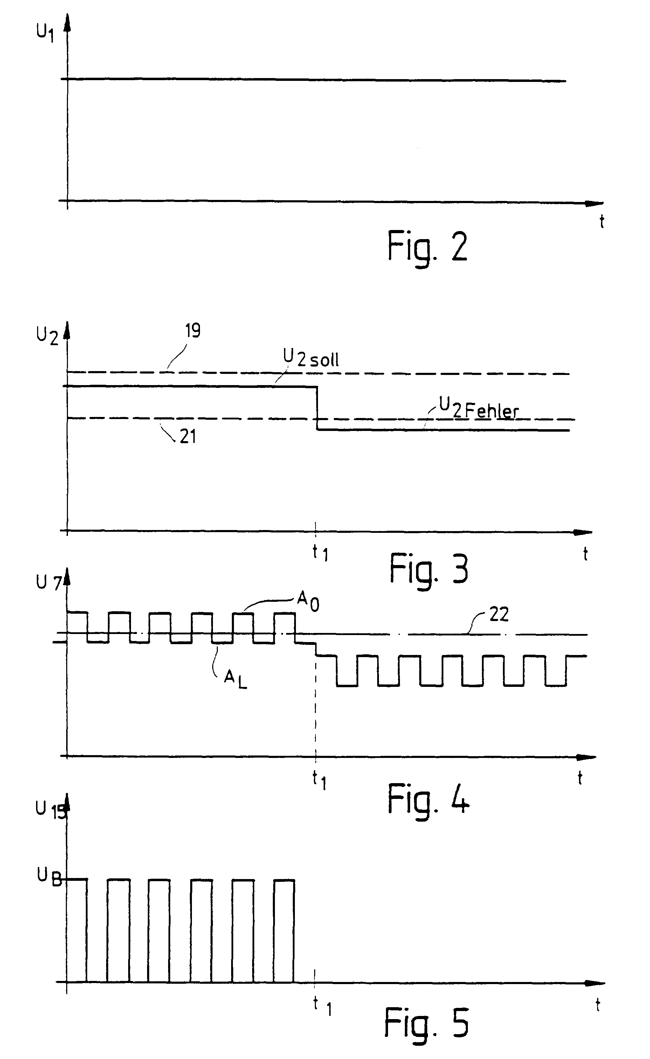

Zur Erläuterung der Funktionsweise der Vorrichtung nach Fig. 1 wird nunmehr im einzelnen auf die Fig. 2 bis 5 Bezug genommen. Wie Fig. 2 erkennen läßt, ist die Gleichspannung U₁ eine über die Zeit invariante Spannung und sie möge die Referenzspannung darstellen, mit der die Spannung U₂ verglichen wird.

Der Verlauf der Spannung U₂ ist in Fig. 3 dargestellt. Diese Spannung U₂ hat bis zum Zeitpunkt t₁ ihren Sollwert U_{2 Soll}. Zum Zeitpunkt t₁ tritt für U₂ ein Fehler auf, was dazu führt, daß U₂ auf einen Wert U_{2 Fehler} fällt. Dieser Wert U_{2 Fehler} ist kleiner als ein zulässiges Toleranzband, innerhalb dessen sich U₂ bewegen darf, ohne daß irgendwelche Störungen auftreten. Die obere Grenze dieses Toleranzbandes ist in Fig. 3 durch eine gestrichelte Linie 19 und die untere Grenze durch eine gestrichelte Linie 21 veranschaulicht.

Die Spannungskonvertierungsschaltung 2 hat den Zweck, die eingespeiste Gleichspannung U₂ mit der am Steuereingang 6 ebenfalls eingespeisten Rechteckspannung 8 zu überlagern, so daß an dem Ausgang 7 eine Spannung U₇ erscheint, deren zeitlicher Verlauf in Fig. 4 gezeigt ist. Es handelt sich hierbei um eine Gleichspannung, die im Takt der zugeführten Rechteckspannung 8 zwischen einem oberen Amplitudenwert Aₒ und einem unteren Amplitudenwert A₁ rechteckförmig hin- und herschwankt. Die Beträge von Aₒ und A₁ sind, wie Fig. 4 erkennen läßt, beide größer als null und sie entsprechen dem oberen bzw. dem unteren Grenzwert 19, 21, zwischen denen sich die zu überwachende Gleichspannung U₂ zulässigerweise bewegen darf.

In Fig. 4 ist ferner als gestrichelte Linie 22 die Schaltschwelle des Komparators 3 eingezeichnet, die nach Betrag und Vorzeichen mit der durch die Spannung U₁ definierten Referenzspannung übereinstimmt. Da eingangs angenommen wurde, daß bis zum Zeitpunkt t₁ U₂ den Sollwert hat, schwankt die daraufhin von der Spannungskonvertierungsschaltung 3 erzeugte Ausgangsspannung U₇ ständig um die Referenzspannung, gegeben durch U₁ hin und her, d.h. der obere Amplitudenwert Aₒ übersteigt die Referenzspannung, während der untere Amplitudenwert A₁ unterhalb der Schaltschwelle liegt. Dementsprechend erzeugt der Komparator 3 an seinem Ausgang 15 die in Fig. 5 gezeigte Rechteckspannung U₁₅, die bis zum Zeitpunkt t₁ ständig zwischen null und U_{B} hin- und herspringt. Somit wird bis zum Zeitpunkt t₁ der Spannungswandler 4 an seinem Eingang 16 mit einer unipolaren Rechteckschwingung beaufschlagt, die er in noch zu beschreibender Weise in die systemfremde Spannung U_{A} wandelt.

Zum Zeitpunkt t₁ möge ein Fehler auftreten, der die Spannung U₂ auf den Wert U_{2 Fehler} zusammenbrechen läßt, der kleiner ist als der untere Spannungsgrenzwert 21. Aufgrund dieses Fehlers verschieben sich der obere und der untere Amplitudenwert Aₒ und A₁ von U₇ in Richtung auf kleinere Beträge. Durch die spezielle, weiter unten beschriebene Ausgestaltung der Spannungskonvertierungsschaltung 2 bleibt der Abstand zwischen dem oberen Amplitudenwert Aₒ und dem unteren Amplitudenwert A₁ im wesentlichen gleich. Jedoch ist nun der obere Amplitudenwert Aₒ entsprechend kleiner als der Schwellwert 22 des Spannungskomparators 3. Die Ausgangsspannung U₇ ist nach dem Auftreten des Fehlers, also nach t₁, auch mit dem oberen Amplitudenwert Aₒ kleiner als der Referenzwert 22, weshalb der Ausgang 15 des Spannungskomparators 3 nach dem Zeitpunkt t₁ auf null bleibt.

Würde zum Zeitpunkt t₁ die Spannung U₂ nicht kleiner als die untere Spannungsgrenze 21, sondern größer als die obere Spannungsgrenze 19 werden, dann würde sich die Spannung U₇ nach dem Zeitpunkt t₁ nach oben verschieben, und zwar so, daß der untere Amplitudenwert A₁ größer ist als die Schaltschwelle 22. Der Spannungskomparator 3 würde daraufhin an seinem Ausgang 15 ebenfalls eine Dauerspannung liefern, die etwa bei U_{B} liegt.

Lediglich solange sich U₂ zwischen den beiden Grenzspannungen 19 und 21 befindet, erzeugt der Spannungskomparator 3 an seinem Ausgang 15 die in Fig. 5 links von t₁ gezeigte unipolare Rechteckspannung. Beim Über- oder Unterschreiben der Spannungsgrenzwerte 19 und 21 entstehen am Ausgang 15 Dauergleichspannungen, die entweder null oder gleich U_{B} sind, abhängig davon, ob die obere Toleranzgrenze 19 oder die untere Toleranzgrenze 21 über- bzw. unterschritten werden.

Aus der oben gegebenen Funktionsbeschreibung der Vorrichtung nach Fig. 1 ergibt sich im übrigen auch, daß der untere Amplitudenwert A₁ der Spannung U₇ mit dem oberen Spannungsgrenzwert 19 korrespondiert, während der obere Amplitudenwert Aₒ mit der unteren Grenzspannung 19 korrespondiert. Die Konsequenz hieraus ist, daß die Schaltschwelle 22 näher an dem unteren Amplitudenwert A₁ liegt, wenn das Toleranzfeld für U₂ oberhalb des Sollwertes schmäler ist als das Toleranzfeld für die untere zulässige Grenzspannung. Die gegebene Erläuterung läßt eine weitere Eigenschaft der neuen Vorrichtung erkennen. Es kann nämlich die Referenzspannung auch von U₂ gebildet sein, während die zu überwachende Spannung die Spannung U₁ darstellt. In diesem Falle würde der Referenzspannung die Rechteckspannung überlagert werden, was u.a. zur Folge hätte, daß der obere Amplitudenwert Aₒ mit der oberen Grenzspannung 19 und der untere Amplitudenwert A₁ mit der unteren Grenzspannung 21 korrespondiert.

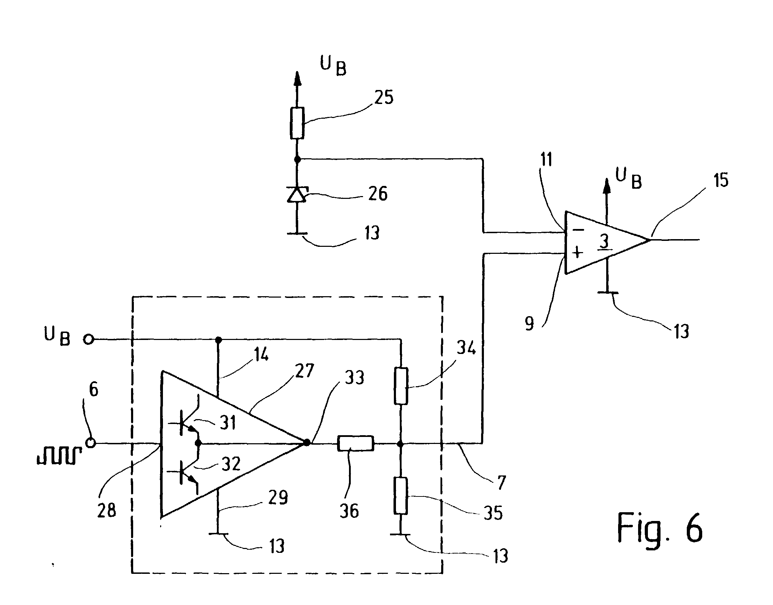

Fig. 6 zeigt ein vereinfachtes Schaltbild zur Erzeugung der Spannung U₁ sowie der Spannungskonvertierungsschaltung 2, wobei die zu überwachende Spannung die Versorgungsspannung U_{B} darstellt.

Aus der Spannung U_{B} wird die Spannung U₁ erzeugt, indem der Eingang 11 des Spannungskomparators 3 über einen Widerstand 25 mit der Versorgungsspannung U_{B} verbunden wird. Ferner ist von dem invertierenden Eingang 11 eine Z-Diode 26 zu der Schaltungsmasse 13 geschaltet. Auf diese Weise wird dem invertierenden Eingang 11 die Spannung U₁ oder Referenzspannung zugeführt, die in weiten Grenzen von der Größe der Versorgungsspannung U_{B} im wesentlichen unabhängig ist. Beispielsweise ist die Größe der Versorgungsspannung U_{B} 5 V, wie dies zur Versorgung von Digitalschaltungen üblich ist. Die charakteristische Spannung der Z-Diode 26 betrage unter diesen Annahmen 2,5 V, d.h. die Referenzspannung hat den Wert 2,5 V.

Die Spannungskonvertierungsschaltung 2 enthält einen Inverter 27, dessen Eingang 28 mit dem Steuereingang 6 verbunden ist. Der Inverter 27 ist mit einem Anschluß 29 an die Schaltungsmasse 13 angeschlossen, während ein anderer Stromversorgungseingang 14 an der zu überwachenden Versorgungsspannung U_{B} liegt. Der Inverter 27 wird beispielsweise von einem C-MOS-NAND-Glied gebildet, dessen Eingänge parallelgeschaltet sind und den Eingang 28 darstellen. Derartige C-MOS-NAND-Glieder enthalten eine Gegentaktendstufe, gebildet aus zwei in Serie geschalteten NPN-Transistoren 31 und 32, wobei die Verbindungsstelle zwischen dem Kollektor des Transistors 32 und dem Emitter des Transistors 31 den Ausgangsanschluß 33 des Inverters 27 darstellt. Die übrigen Bauelemente des Inverters 27 sind nicht weiter dargestellt, da sie für das Verständnis der Wirkungsweise der Schaltung ansonsten nicht von Bedeutung sind. Im übrigen kann der Aufbau eines derartigen C-MOS-Gliedes in beliebigen Datenkatalogen nachgeschlagen werden.

Zu der Versorgungsspannung U_{B} liegt ein Spannungsteiler aus Widerständen 34 und 35 parallel, wobei die Verbindungsstelle zwischen den beiden Widerständen 34 und 35 den Ausgang 7 der Spannungskonvertierungsschaltung 2 darstellt. Mit diesem Ausgang 7 ist ein weiterer Widerstand 36 verbunden, dessen anderes Ende an den Ausgang 33 des Inverters 27 angeschlossen ist.

Zusätzlich zu der bereits oben getroffenen Annahme, daß die Versorgungsspannung U_{B} 5V beträgt, sei ferner angenommen, daß die maximal zulässige Versorgungsspannung U_{B} 5,5V und die minimal zulässige Versorgungsspannung 4,5V betragen möge. Unter diesen Umständen sind die beiden Widerstände 34 und 35 gleich groß.

Wenn in den Steuereingang 6 die Rechteckspannung 8 eingespeist wird, wird abwechselnd der Transistor 31 oder der Transistor 32 vollständig durchgesteuert, während der jeweils andere Transistor vollständig gesperrt ist. Die Folge davon ist, daß der Ausgang 33 entweder über den Stromversorgungsanschluß 29 mit der Schaltungsmasse 13 oder über den Stromversorgungsanschluß 27 mit der Versorgungsspannung U_{B} verbunden ist, denn zwischen der Versorgungsspannung U_{B} und der Schaltungsmasse 13 liegt die Kaskade aus den beiden Transistoren 31 und 32. Für die weitere Bemessung der Schaltung sei vereinfachend angenommen, daß die Durchlaßspannung der beiden Transistoren 31 und 32 verschwindend klein ist. Unter diesen Umständen muß dann der Widerstand 36 ca. 5,12-mal so groß werden wie der Widerstand 35 oder der Widerstand 34, wie sich dies aus der weiter unten angegebenen Bedingung ergibt.

Je nach Schaltzustand der beiden Transistoren 31 und 32 liegt der Widerstand 36 entweder zu dem Widerstand 34 oder dem Widerstand 35 parallel. Da die Referenzspannung halb so groß ist wie die Versorgungsspannung U_{B} und die Versorgungsspannung U_{B} zwischen den Grenzwerten 5,5 als oberem Wert und 4,5 als unterem Wert schwanken kann, muß der obere und der untere Amplitudenwert der Spannung U₇ auf 2,75 bzw. 2,25 V liegen, wenn die Versorgungsspannung U_{B} ihren Sollwert von 5 V hat.

Solange nun die Spannung U_{B} kleiner bleibt als 5,5 V aber größer als 4,5 V, erzeugt die Spannungskonvertierungsschaltung 2 an dem Ausgang 7 eine Spannung, die ständig um den Referenzwert von 2,5 V herumspringt. Wird die Spannung U_{B} größer als 5,5 V, dann schwankt die Spannung U₇ nicht mehr zwischen 2,25 V und 2,75 V hin und her, sondern der untere Amplitudenwert A_{L} steigt auf 2,51 V an, wenn der Widerstand 36 wie oben angenommen ca. um den Faktor 5,12 größer ist als die Widerstände 34 und 35. Sinngemäß das Umgekehrte geschieht, falls die Spannung U_{B} unter den unteren zulässigen Grenzwert fällt, womit jenseits der beiden Grenzwerte von 4,5 und 5,5 V der Spannungskomparator 3, wie oben ausführlich dargelegt, ein Dauersignal liefern würde. Nur solange wie sich U_{B} zwischen den genannten Grenzen befindet, erzeugt der Spannungskomparator 3 an seinem Ausgang 15 das erforderliche Rechtecksignal.

Bei der Erläuterung des Ausführungsbeispiels wurde unterstellt, daß der Spannungskomparator 3 eine gegen null gehende Schalthysterese hat. Sollte der Spannungskomparator 3 eine Schalthysterese haben, müssen der oberen und der unteren Amplitudenwert dementsprechend korrigiert werden, bis die oben erläuterte Funktion zustandekommt.

Bei der Ausführungsform nach Fig. 6 arbeitet die Spannungskonvertierungsschaltung 2 wie ein "schlechter" Addierer insofern, als zu der über die beiden Widerstände 34 und 35 erzeugten Spannung über den Widerstand 36 eine weitere Spannung hinzuaddiert oder davon subtrahiert wird.

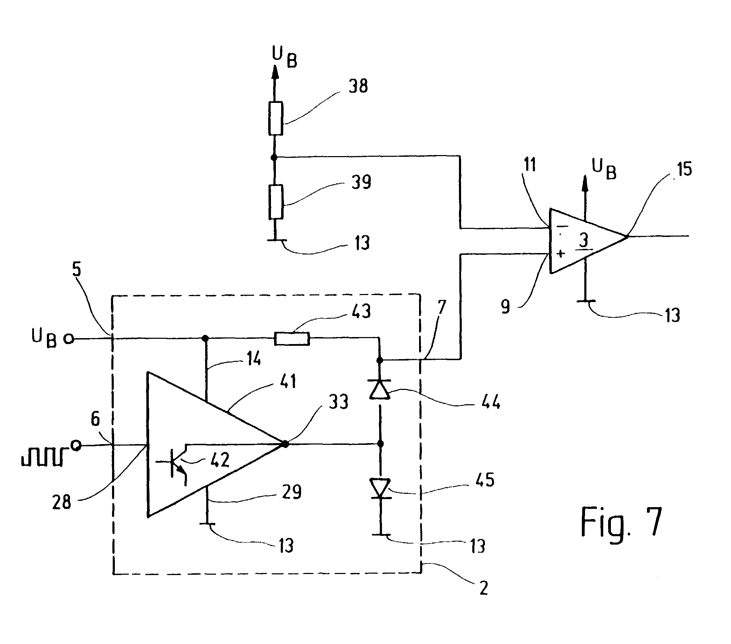

Fig. 7 zeigt ein Ausfführungsbeispiel, bei dem die Spannung U₂ die Referenzspannung darstellt, die in die Spannungskonvertierungsschaltung 2 gelangt. Der invertierende Eingang 11 des Spannungskomparators 3 liegt an der Verbindungsstelle zwischen zwei in Serie geschalteten Widerständen 38 und 39, von denen der eine mit der Schaltungsmasse 13 und der andere mit der Versorgungsspannung U_{B} verbunden ist. Die beiden Widerstände 38 und 39 mögen gleich groß sein und erzeugen so eine Spannung U₁, die halb so groß ist wie U_{B}.

Die Spannungskonvertierungsschaltung 2 enthält wiederum einen Inverter 41, der jedoch diesmal aus einem NOR-Glied mit Open-Kollektorausgang ist, d.h. der Inverter 41 enthält lediglich einen Ausgangstransistor 42, dessen Emitter mit dem Stromversorgungseingang 29 verbunden und somit an der Schaltungsmasse 13 liegt und dessen Kollektor den Ausgang 33 darstellt. Der Eingang 28 des Inverters 41 ist wiederum der Steuereingang 6, während der positive Versorgungsspannungsanschluß 14 den Eingang 5 darstellt, an den die Versorgungsspannung U_{B} angeschlossen ist. Von dem Eingang 5 führt innerhalb der Spannungskonvertierungsschaltung 2 ein Widerstand 43 zu dem Ausgang 7, der über die Hintereinanderschaltung einer Z-Diode 44 und einer in Durchlaßrichtung gepolten Diode 45 mit der Schaltungsmasse 13 verbunden ist. An der Verbindungsstelle zwischen der Z-Diode 44 und der Diode 45 ist der Ausgang 33 angeschlossen.

Die in Durchlaßrichtung gepolte Diode 45 erzeugt normalerweise einen Spannungsabfall von O,6 V, wenn sie in Durchgangsrichtung vom Strom durchflossen wird. Unter dieser Annahme wird die Z-Diode 44 so gewählt, daß an ihr ein Spannungsabfall von 2,1 V entsteht.

Sobald in den Steuereingang 6 die Rechteckspannung 8 eingespeist wird, wird im Takt der Rechteckspannung 8 der Transistor 42 auf- bzw. zugesteuert. Im aufgesteuerten Zustand schließt er die Diode 45 kurz, während im gesperrten Zustand die Diode 45 einen Spannungsabfall erzeugt, der zu dem Spannungsabfall der Z-Diode 44 hinzukommt. Die Spannung an dem Ausgang 7 schaltet somit zwischen 2,7 und 2,1 V hin und her. Damit unter diesen Umständen der Spannungskomparator 3 die Rechteckspannung an seinem Ausgang 15 erzeugen kann, muß die Versorgungsspannung U_{B} kleiner als 5,4 V, aber größer als 4,2 V sein. Somit ist die beschriebene und dimensionierte Schaltung geeignet, die Versorugngsspannung U_{B} auf Einhalten dieser Grenzwerte zu überwachen.

Es ist jedoch ohne weiteres möglich, andere Dimensionierungen vorzusehen. Auch wäre es denkbar, anstelle des Spannungsteilers aus den beiden Widerständen 38 und 39 die Stabilisierungsschaltung nach Fig. 6 aus dem Widerstand 25 und der Z-Diode 26 einzusetzen, so daß der invertierende Eingang 11 wiederum die Referenzspannung erhält, während die Z-Diode 44 durch einenn ohmschen Widerstand ersetzt wird, so daß der Fußpunkt des jetzt aus zwei Widerständen bestehenden Spannungsteilers mit Hilfe der Diode 45 zwischen zwei verschiedenen Potentialen umgeschaltet wird. Auch dadurch läßt sich die gewünschte Spannung an dem Ausgang 7 erzeugen, um die oben erläuterte Funktion zu erhalten. Wesentlich dabei ist lediglich, daß die Spannungskonvertierungsschaltung 2 an dem Ausgang 7 eine Spannung liefert, die zwischen einem oberen und einem unteren Amplitudenwert Aₒ, A_{L} hin- und herspringt und diese beiden Werte mit einem oberen bzw. einem unteren Spannungsgrenzwert der zu überwachenden anderen Spannung korrespondieren. Die Bemessung muß so erfolgen, daß, wenn die andere zu überwachende Spannung den durch diese beiden Grenzwerte definierten Bereich verläßt, der Komparator 3 an seinem Ausgang anstelle eines Wechselsignals ein Dauergleichsignal liefert.

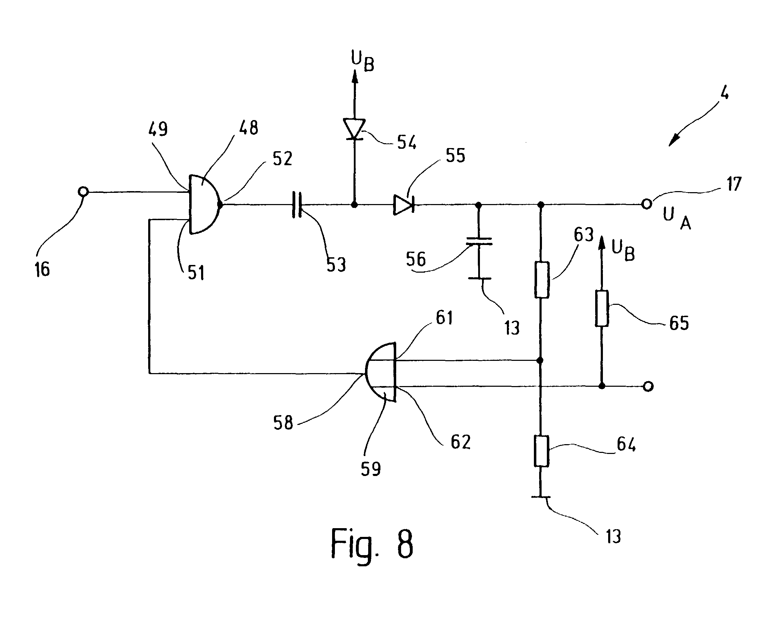

Fig. 8 zeigt das Prinzipschaltbild für den in der neuen Vorrichtung verwendeten Spannungswandler 4 zum Erzeugen der systemfremden Spannung. Unter "systemfremder" Spannung wird eine Spannung verstanden, die unter Berücksichtigung von Betrag und Vorzeichen größer oder kleiner ist als die größte oder die kleinste in der Schaltung auftretende Versorgungsspannung oder die von der Versorgungsspannung galvanisch getrennt ist. Für das oben erläuterte Ausführungsbeispiel wären systemfremde Spannungen Spannungen größer als 5,5 V oder kleiner als 0 V, falls diese Spannungen galvanisch mit der überwachten Schaltung verbunden sind.

Der in Fig. 8 gezeigte Spannungswandler soll eine Spannung erzeugen, die größer als 5,5 V ist. Er enthält in seinem Eingang ein NAND-Glied 48 mit zwei Eingängen 49 und 51 sowie einem invertierenden Ausgang 52. Der Eingang 49 bildet gleichzeitig den Eingang 16 des Spannungswandlers 4.

An den invertierenden Ausgang 52 ist ein Kondensator 53 angeschlossen, dessen andere Elektrode über eine Diode 54 an der Versorgungsspannung U_{B} liegt. Eine weitere Diode 55 führt von der Verbindungsstelle zwischen der Diode 55 und dem Kondensator 53 zu einem Sieb- oder Glättungskondensator 56, der anderenends mit der Schaltungsmasse 13 verbunden ist. An die Verbindungsstelle zwischen der Diode 55 und den Kondensator 56 ist der Ausgang 17 des Spannungswandlers 4 angeschlossen.

Um ein Wiederanlaufen des Spannungswandlers 4 zu verhindern, falls einmal an seinem Eingang 16 die Wechselspannung ausgesetzt hat, ist eine von dem Ausgang 17 zu dem anderen Eingang 51 des NAND-Gliedes 48 führende Rückkopplung vorgesehen. Diese Rückkopplung enthält ein mit seinem Ausgang 58 an den Eingang 51 angeschlossenes ODER-Glied 59 mit zwei Eingängen 61 und 62 liegt. Der Eingang 61 ist über einen Spannungsteiler, gebildet aus zwei Widerständen 63 und 64, mit dem Ausgang 17 verbunden. Das andere Ende des Spannungsteilers liegt an der Schaltungsmasse 13.

Um den Spannungswandler 4 nach einem Abschaltvorgang gesperrt halten zu können, ist der Eingang 62 über einen Widerstand 65 an die Schaltungsmasse 13 angeschaltet;im übrigen ist der Eingang 62 der Enable- oder Freigabeingang.

Der insoweit beschriebene Spannungswandler 4 arbeitet wie folgt:

Wenn der Spannungskomparator 3 die Ausgangswechselspannung gemäß Fig. 5 abgibt, weil die miteinander zu vergleichenden Spannungen U₁ und U₂ unter Berücksichtigung des zulässigen Toleranzfeldes gleich sind, wird der Eingang 49 des NAND-Gliedes 48 periodisch mit einem zwischen "low" und "high" hin- und herwechselnden Signal beaufschlagt. Angenommen der andere Eingang 51 liegt auf "high", dann wechselt der Pegel am invertierenden Ausgang 52 ebenfalls periodische zwischen "low" und "high" hin und her. Im Zustand "low" wird der Kondensator 53 über die in Durchlaßrichtung gepolte Diode 54 auf die Versorgungsspannung aufgeladen. Wenn anschließend der invertierende Ausgang 52 auf "high" geht und damit eine Spannung entsprechend der Versorgungsspannung U_{B} aufweist, addiert sich zu der Spannung an dem invertierenden Ausgang 52 die in dem Kondensator 53 gespeicherte Spannung, die betragsmäßig so groß ist wie U_{B}. Die Diode 54 ist jetzt in Sperrichtung vorgespannt, denn die Verbindungsstelle zwischen der Kathode der Diode 54 und dem Kondensator 53 hat nun eine Spannung von ca. zweimal U_{B}. Mit dieser Spannung wird über die Diode 55 der Glättungskondensator 56 aufgeladen. Nach einigen dieser Ladezyklen liefert der Kondensator 56 eine geglättete Gleichspannung, die die Größe zweimal U_{B} hat. Die Gleichspannung steht auch an dem Ausgang 17 an und stellt somit die erforderliche systemfremde Spannung dar, die in weiteren Steuerschaltungen ausgewertet wird, beispielsweise einer zentralen CPU.

Außerdem wird die Spannung an dem Ausgang 17 an dem Spannungsteiler aus den Widerständen 63 und 64 wiederum auf U_{B} halbiert und dem Eingang 61 zugeführt. Obwohl der andere Eingang 62 über den Widerstand 65 auf "low" liegt, geht der Ausgang 58 auf "high". Dieses Signal wird dem Eingang 51 zugeführt. Der Spannungswandler 4 ist somit dauernd funktionsfähig, solange, bis das Wechselsignal an seinem Eingang für eine genügend lange Zeit unterbrochen ist, solange nämlich, bis der Kondensator 56 über den Spannungsteiler aus den Widerständen 63 und 64 weit genug entladen ist, damit an dem Eingang 51 das "high"-Signal verschwindet. Wenn dies eingetreten ist, erzeugt der Spannungswandler 4 an seinem Ausgang 17 auch dann nicht mehr die erforderliche Spannung, wenn der Spannungskomparatur 3 erneut beginnen sollte, das Wechselsignal zu erzeugen. Erst eine Freigabe an dem Freigabeeingang 62 durch ein "high"- Signal läßt den Spannungswandler 4 erneut arbeiten.

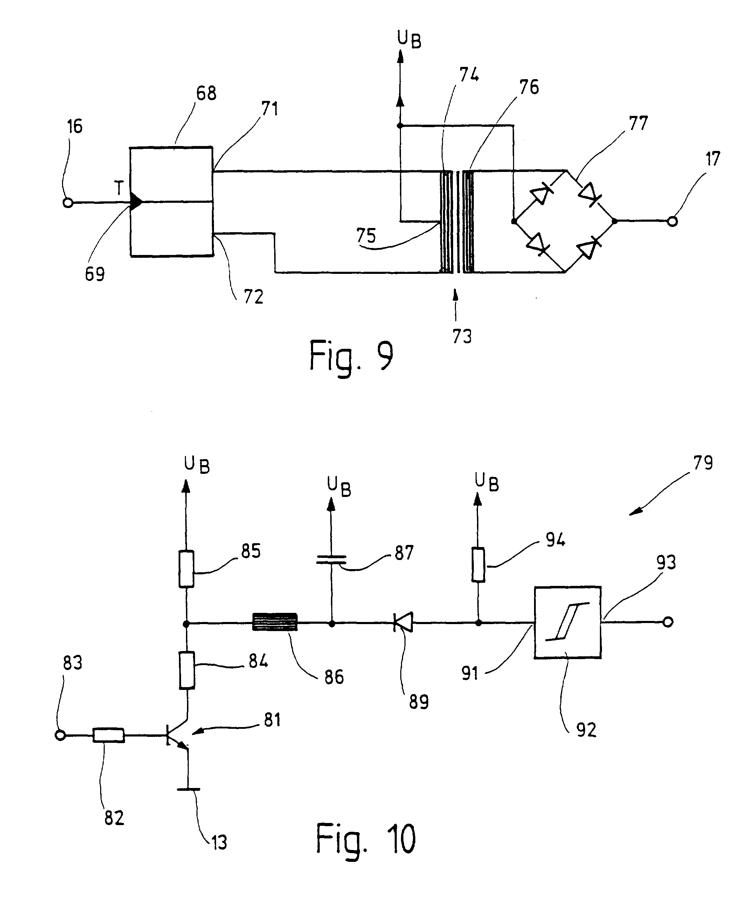

Die systemfremde Spannung kann auch mit Hilfe eines T-Flipflops 68 mit Open Collektor Ausgängen erzeugt werden, wie es in Fig. 9 veranschaulicht ist. Ein Takteingang 69 des T-Flipflops ist an den Eingang 16 des Spannungswandlers 4 angeschlossen, während an zwei zueinander komplementären Ausgängen 71 und 72 des T-Flipflops 68 ein Gegentakttransformator 73 angeschaltet ist. Der Transformator 73 enthält eine mittenangezapfte Primärwicklung 74, deren Mittelanzapfung 75 an der Versorgungsspannung U_{B} liegt sowie eine Sekundärwicklung 76, die mit Wechselspannungsanschlüssen eines Brückengleichrichters 77 verbunden ist. Der negative Anschluß des Brückengleichrichters 77 liegt ebenfalls auf dem Potential der Versorgungsspannung U_{B} und der positive Ausgang des Brückengleichrichters 77 stellt den Ausgang 17 des Spannungswandlers 4 dar.

Wenn es sich bei dem T-Flipflop um ein negativ flankengetriggertes Flipflop handelt, wechselt es mit jedem Eintreffen einer negativen Flanke, die von dem Spannungskomparator 3 an dem Ausgang 15 abgegeben wird, seinen Zustand, so daß im Takt der eingespeisten Wechselspannung die Ausgänge 71 und 72 periodisch umschalten, wobei die beiden Ausgänge 71 und 72 gegenphasig zueinander sind. Hierdurch wird in der Primärwicklung 74 in jeder Teilwicklung ein entsprechender Strom erzeugt, der eine Spannung in der Sekundärwicklung 76 zur Folge hat. Die an der galvanisch getrennten Wicklung 76 erzeugte Spannung wirkt in dem Brückengleichrichter 77 gleichgerichtet und, da der Brückengleichrichter mit seinem negativen Anschluß an die Versorgungsspannung U_{B} angeschlossen ist, ist die von dem Brückengleichrichter 77 abgegebene Spannung die Summe aus der Spannung U_{B} zuzüglich der an der Sekundärwicklung 76 anstehenden Spannung.

Die Spannung an dem Ausgang 17 stellt damit auch eine systemfremde Spannung dar, solange der Takteingang 69 des T-Flipflops ein Wechselspannungssignal erhält.

Fällt hingegen das Wechselsignal aus, verschwindet auch die Spannung in der Sekundärwicklung 76 und die Spannung U_{A} am Ausgang 17 wird entsprechend kleiner, was von der nachfolgenden Schaltung ausgewertet werden kann.

Wenn im Interesse einer noch höheren Sicherheit ausgeschlossen werden soll, daß trotz ausgefallener Wechselspannung an dem Ausgang 15 des Spannungskomparators 3 vagabundierende Wechselspannungen, beispielsweise aus einem fehlerhaften Netzgerät oder infolge schwingender integrierter Schaltungen, den Spannungswandler 4 zum Arbeiten bringt, kann zusätzlich noch ein Frequenzdiskriminator 79 verwendet werden, wie er in Fig. 10 gezeigt ist. Der Frequenzdiskriminator 79 enthält eingangsseitig einen Transistor 81, dessen Basis über einen Widerstand 82 an einen Diskriminatoreingang 83 angeschlossen ist. Der Emitter des Transistors 81 liegt an der Schaltungsmasse 13, während der Kollektor über die Hintereinanderschaltung zweier Widerstände 84 und 85 die Versorgungsspannung U_{B} erhält. An der Verbindungsstelle der beiden Widerstände 84 und 85 ist ein Serienschwingkreis, bestehend aus einer Induktivität 86 und einem Kondensator 87 angeschaltet, der andernends an der Versorgungsspannung U_{B} liegt. Von der Verbindungsstelle zwischen der Induktivität 86 und dem Kondensator 87 geht eine Diode 89 ab, die anodenseitig zu einem Eingang 91 eines Schmitt-Triggers 92 führt, dessen Ausgang 93 der Ausgang des Frequenzdiskriminators 79 ist. Zur Erzeugung einer mittleren Vorspannung für den Schmitt-Trigger 92 ist der Eingang 91 außerdem über einen Widerstand 94 mit der Versorgungsspannung U_{B} verbunden.

Zur Überwachung der Frequenz an dem Ausgang 15 des Spannungskomparators 3 wird der Eingang 83 mit dem Ausgang 15 verbunden. Das dort erzeugte Wechselsignal gelangt in den Transistor 81, der den Serienschwingkreis aus den Bauteilen 86 und 87 anregt. Die Resonanzfrequenz dieses Serienschwingkreises ist auf die Taktfrequenz des Rechtecksignals 8 abgestimmt, so daß an der Anode der Diode 89 nur dann ein Signalpegel ansteht, der in der Lage ist, den Schmitt-Trigger 92 auszusteuern, wenn die Frequenz des Rechtecksignals 8 hinreichend mit der Resonanzfrequenz übereinstimmt. Weichen die Frequenzen zu stark voneinander ab, entsteht an dem Kondendensator 87 keine Resonanzüberhöhung mehr und die Spannung genügt nicht, um den Schmitt-Trigger 92 periodisch umzuschalten. Das fehlende Wechselsignal an dem Ausgang 93 des Schmitt-Triggers 92 ist dann ein Hinweis darauf, daß das Rechtecksignal 8 entweder vollkommen fehlt oder eine Frequenz hat, die nicht mit der Resonanzfrequenz des Serienschwingkreises aus dem Kondensator 87 und der Induktivität 86 übereinstimmt. Durch Überwachung des Signals an dem Ausgang 93 kann sichergestellt werden, daß die systemfremde Spannung U_{A} nur dann als Kennzeichen dafür angesehen wird, daß der Vergleich der beiden Spannungen U₁ und U₂ positiv ausgefallen ist, wenn auch gleichzeitig an dem Ausgang 83 das Wechselsignal auftritt.

Bei einer praktischen Ausführungsform sind die Widerständ 84 und 85 sowie die Schwingkreisgüte derart bemessen, daß bei Resonanz die Spannung an der Kathode der Diode 89 10 V Scheitel-Scheitel bei einem Mittelwert von +5 V beträgt.

Eine andere Möglichkeit der Überwachung besteht darin, den Frequenzdiskriminator 79, wie er in Fig. 10 gezeigt ist, in die Verbindungsleitung zwischen dem Ausgang 15 des Spannungskomparators 3 und den Eingang 16 des Spannungswandlers 4 zu schalten.

Eine Vorrichtung zum Vergleichen zweier Gleichspannungen enthält einen Spannungskomparator mit zwei Eingängen. In einen der Eingänge wird die eine der beiden miteinander zu vergleichenden Spannungen unmittelbar eingespeist. Die andere Spannung gelangt in eine Spannungskonvertierungseinrichtung, in der die zu vergleichende Spannung mit einer Wechselspannung überlagert wird, so daß am Ausgang der Spannungskonvertierungseinrichtung eine Gleichspannung entsteht, die im Takt des Rechtecksignals periodisch zwischen einem oberen und einem unteren Amplitudenwert hin- und herschwankt. Der Abstand der beiden Amplitudenwerte entspricht dem Toleranzband, innerhalb dem die beiden miteinander zu vergleichenden Spannungen gleich sein müssen. Das aus der Spannungskonvertierungsschaltung gewonnene Spannungssignal gelangt in den anderen Eingang des Spannungskomparators, der an seinem Ausgang nur dann ein Wechselsignal liefert, wenn der obere Amplitudenwert größer und der untere Amplitudenwert kleiner ist als das in den anderen Eingang des Komparators eingespeiste Gleichsignal.

Das aus dem Komparator enthaltene Wechselsignal gelangt in einen Spannungswandler, der daraus eine systemfremde Spannung erzeugt.

## Patentansprüche

1. Vorrichtung zum Vergleichen einer ersten Gleichspannung (U₁) mit einer zweiten Gleichspannung (U₂),
mit einem zwei Eingänge (9,11) aufweisenden Komparator (3), an dessen ersten Eingang (11) die erste Gleichspannung (U₁) angelegt ist,
mit einer Spannungkonvertierungseinrichtung (2), die einen Steuereingang (6), in den ein Wechselsignal (8) eingespeist wird, einen Signaleingang (5), in den die zweite Gleichspannung (U₂) eingespeist wird, und einen an den zweiten Eingang (9) des Komparators (3) angeschlossenen Ausgang (7) aufweist, der bei Anliegen der Spannungen an den Eingängen (5,6) eine Spannung (U₇) abgibt, die periodisch zwischen einem oberen Amplitudenwert (A_{O}) und einem unteren Amplitudenwert (A_{L}) hin- und herwechselt, wobei die Differenz zwischen den beiden Amplitudenwerten (A_{O}, A_{L}) im wesentlichen gleich einem vorbestimmten Differenzwert ist.

2. Vorrichtung nach Anspruch 1, dadurch gekennzeichnet, daß die Spannungkonvertierungseinrichtung (2) von einer Summiereinrichtung gebildet ist, in der zu einer aus der zweiten Gleichspannung (U₂) abgeleiteten Spannung eine Wechselspannung (8) hinzuaddiert wird.

3. Vorrichtung nach Anspruch 1, dadurch gekennzeichnet, daß die erste Gleichspannung (U₁) einen Sollwert aufweist, daß ein zwischen dem oberen und dem unteren Amplitudenwert (A_{O}, A_{L}) liegender Spannungswert dem Sollwert entspricht und daß der vorbestimmte Differenzwert der zulässigen Toleranzbreite der ersten Gleichspannung (U₁) entspricht.

4. Vorrichtung nach Anspruch 1, dadurch gekennzeichnet, daß die zweite Gleichspannung (U₂) einen Sollwert aufweist und daß ein zwischen dem oberen und dem unteren Amplitudenwert (A_{O}, A_{L}) liegender Spannungswert gleich der ersten Gleichspannung (U₁) ist, wenn die zweite Gleichspannung (U₂) auf ihrem Sollwert ist, und daß der vorbestimmte Differenzwert der zulässigen Toleranzbreite der zweiten Gleichspannung (U₂) entspricht.

5. Vorrichtung nach Anspruch 1, dadurch gekennzeichnet, daß Mittel (34,35;38,39) vorgesehen sind, die aus einer Versorgungsspannung (U_{B}) eine Spannung ableiten, die der Versorgungsspannung (U_{B}) zumindest im wesentlichen propotional oder dessen Änderung der Änderung der Versorgungsspannung (U_{B}) im wesentlichen proportional ist, und daß die abgeleitete Spannung eine der Gleichspannungen (U₁,U₂) bildet.

6. Vorrichtung nach Anspruch 1, dadurch gekennzeichnet, daß Mittel (26,44) vorgesehen sind, die aus einer Versorgungsspannung (U_{B}) eine Spannung ableiten, die von der Versorgungsspannung (U_{B}) zumindest im wesentlichen unabhängig ist und eine im wesentlichen feste Referenzspannung bildet, die eine der beiden Gleichspannungen (U₁,U₂) darstellt.

7. Vorrichtung nach Anspruch 6, dadurch gekennzeichnet, daß die Referenzspannung von der Versorgungspannung (U_{B}) unabhängig ist.

8. Vorrichtung nach Anspruch 1, dadurch gekennzeichnet, daß das Wechselsignal (8) ein Rechtecksignal ist.

9. Vorrichtung nach Anspruch 1, dadurch gekennzeichnet, daß zwischen dem Signaleingang (5) und dem Ausgang (7) der Spannungkonvertierungseinrichtung (2) wenigstens ein ohmscher Widerstand (34,43) enthalten ist.

10. Vorrichtung nach Anspruch 1, dadurch gekennzeichnet, daß zwischen dem Signaleingang (5) und dem Ausgang (7) der Spannungkonvertierungseinrichtung (2) wenigstens ein Element mit der Charakteristik einer Z-Diode enthalten ist.

11. Vorrichtung nach Anspruch 1, dadurch gekennzeichnet, daß zwischen dem Ausgang (7) der Spannungkonvertierungseinrichtung (2) und einer mit dem Komparator (3) gemeinsamen Masse (13) wenigstens ein Element (44,45) mit der Charakteristik einer Z-Diode enthalten ist.

12. Vorrichtung nach Anspruch 1, dadurch gekennzeichnet, daß zwischen dem Ausgang (7) der Spannungkonvertierungseinrichtung (2) und einer mit dem Komparator (3) gemeinsamen Masse (13) wenigstens ein ohmscher Widerstand (35) enthalten ist.

13. Vorrichtung nach Anspruch 1, dadurch gekennzeichnet, daß die Spannungkonvertierungseinrichtung (2) wenigstens einen elektronischen Schalter (31) enthält, durch den periodisch eine zusäztliche Spannung auf den Ausgang (7) der Spannungkonvertierungseinrichtung (2) geschaltet wird.

14. Vorrichtung nach Anspruch 1, dadurch gekennzeichnet, daß die Spannungkonvertierungseinrichtung (2) wenigstens einen elektronischen Schalter (42) enthält, durch den periodisch ein zu dem elektronischen Schalter (42) parallel liegender Zweipol (45) kurzgeschlossen wird.

15. Vorrichtung nach Anspruch 1, dadurch gekennzeichnet, daß sie einen Rechteckgenerator zur Erzeugung des Wechselsignals (8) enthält.

16. Vorrichtung nach Anspruch 1, dadurch gekennzeichnet, daß sie einen an den Ausgang (7) des Komparators (3) angeschlossenen Spannungswandler (4) enthält.

17. Vorrichtung nach Anspruch 16, dadurch gekennzeichnet, daß der Spannungswandler (4) eine Spannung (U_{A}) erzeugt, die eine systemfremde Spannung darstellt.

18. Vorrichtung nach Anspruch 17, dadurch gekennzeichnet, daß die systemfremde Spannung eine von der überwachten Spannung (U_{B}) galvanisch getrennte Spannung ist.

19. Vorrichtung nach Anspruch 17, dadurch gekennzeichnet, daß die systemfremde Spannung eine Spannung ist, die unter Berücksichtigung von Betrag und Vorzeichen größer oder-kleiner als die überwachte Spannung (U_{B}) ist.

20. Vorrichtung nach Anspruch 16, dadurch gekennzeichnet, daß der Spanungswandler (4) ein aus Kondensatoren (53,56) und Dioden (54,55) aufgebauter Spannungvervielfacher ist.

21. Vorrichtung nach Anspruch 16, dadurch gekennzeichnet, daß der Spanungswandler (4) ausgangsseitig einen Trenntransformator (73) enthält.

22. Vorrichtung nach Anspruch 21, dadurch gekennzeichnet, daß eine Ausgangswicklung (76) des Trenntransformators (73) an einen Gleichrichter (77) angeschlossen ist.

23. Vorrichtung nach Anspruch 22, dadurch gekennzeichnet, daß mit der von dem Gleichrichter (77) gelieferten Spannung die überwachte Spannung (U_{B}) in Serie liegt.

24. Vorrichtung nach Anspruch 1, dadurch gekennzeichnet, daß sie einen Frequenzdetektor (79) enthält, in den ein Wechselsignal eingespeist wird und der an seinem Ausgang (93) eine Ausgangsignal abgibt.

25. Vorrichtung nach Anspruch 24, dadurch gekennzeichnet, daß das Wechselsignal das Ausgangssignal des Komparators (3) ist.

26. Vorrichtung nach Anspruch 24, dadurch gekennzeichnet, daß der Frequenzdetektor einen Serienschwingkreis (86,87) enthält, dessen Resonanzfrequenz im wesentlichen mit der Grundfrequenz des Taktsignals übereinstimmt, und daß die Verbindungsstelle der Elemente (86,87) des Serienschwingkreises mit dem Ausgang (93) des Frequenzdetektors (79) verbunden ist.

## Claims

1. Device for comparing a first d.c. voltage (U₁) with a second d.c. voltage (U₂),
with a comparator (3) having two inputs (9, 11) and at the first input (11) of which the first d.c. voltage (U₁) is present,
with a voltage conversion system (2), which has a control input (6), into which an alternating signal (8) is fed, a signal input (5), into which the second d.c. voltage (U₂) is fed, and an output (7), which is connected to the second input (9) of the comparator (3) and, when the voltages are present at the inputs (5, 6), emits a voltage (U₇), which changes periodically back and forth between an upper amplitude value (Aₒ,) and a lower amplitude value (A_{L}), whereby the difference between the two amplitudes (Aₒ, A_{L}) is essentially equal to a predetermined difference.

2. Device according to Claim 1, characterised in that the voltage conversion system (2) is formed by an adder arrangement, in which an alternating voltage (8) is added to a voltage derived from the second d.c. voltage (U₂).

3. Device according to Claim 1, characterised in that the first d.c. voltage (U₁) has a nominal value; that a voltage value lying between the upper and the lower amplitude values (Aₒ, A_{L}) corresponds to the nominal value; and that the predetermined difference corresponds to the permissible tolerance range of the first d.c. voltage (U₁).

4. Device according to Claim 1, characterised in that the second d.c. voltage (U₂) has a nominal value; and that a voltage value lying between the upper and the lower amplitudes (Aₒ, A_{L}) is equal to the first d.c. voltage (U₁), when the second d.c. voltage (U₂) is at its nominal value; and that the predetermined difference corresponds to the permissible tolerance range of the second d.c. voltage (U₂).

5. Device according to Claim 1, characterised in that means (34, 35; 38, 39) are provided which derive from a supply voltage (U_{B}) a voltage which is at least essentially proportional to the supply voltage (U_{B}) or is essentially proportional to the change in the supply voltage (U_{B}) ; and that the derived voltage forms one of the d.c. voltages (U₁, U₂).

6. Device according to Claim 1, characterised in that means (26, 44) are provided which derive from a supply voltage (U_{B}) a voltage which is at least essentially independent of the supply voltage (U_{B}), and forms an essentially fixed reference voltage, which represents one of the two d.c. voltages (U₁, U₂).

7. Device according to Claim 6, characterised in that the reference voltage is independent of the supply voltage (U_{B}).

8. Device according to Claim 1, characterised in that the alternating signal (8) is a square wave signal.

9. Device according to Claim 1, characterised in that at least one ohmic resistance (34, 43) is included between the signal input (5) and the output (7) of the voltage conversion system (2).

10. Device according to Claim 1, characterised in that at least one element with the characteristic of a Z-diode is included between the signal input (5) and the output (7) of the voltage conversion system (2).

11. Device according to Claim 1, characterised in that at least one element (44, 45) with the characteristic of a Z-diode is included between the output (7) of the voltage conversion system (2) and a ground (13) common with the comparator (3).

12. Device according to Claim 1, characterised in that at least one ohmic resistance (35) is included between the output (7) of the voltage conversion system (2) and a ground (13) common with the comparator (3).

13. Device according to Claim 1, characterised in that the voltage conversion system (2) includes at least one electronic switch (31), through which an additional voltage is periodically switched onto the output (7) of the voltage conversion system (2).

14. Device according to Claim 1, characterised in that the voltage conversion system (2) includes at least one electronic switch (42), by which a two-terminal network (45) connected across the electronic switch (42) is periodically short-circuited.

15. Device according to Claim 1, characterised in that it includes a square wave generator for generation of the alternating signal (8).

16. Device according to Claim 1, characterised in that it includes a voltage converter (4) connected to the output (7) of the comparator (3).

17. Device according to Claim 16, characterised in that the voltage converter (4) generates a voltage (U_{A}) which represents a voltage foreign to the system.

18. Device according to Claim 17, characterised in that the voltage foreign to the system is a voltage electrically isolated from the monitored voltage (U_{B}).

19. Device according to Claim 17, characterised in that the voltage foreign to the system is higher or lower than the monitored voltage (U_{B}) taking into account its absolute value and its sign.

20. Device according to Claim 16, characterised in that the voltage converter (4) is a voltage multiplier composed of capacitors (53, 56) and diodes (54,55).

21. Device according to Claim 16, characterised in that the voltage converter (4) includes an isolating transformer (73) on the output side.

22. Device according to Claim 21, characterised in that an output winding (76) of the isolating transformer (73) is connected to a rectifier (77).

23. Device according to Claim 22, characterised in that the monitored voltage (U_{B}) is connected in series to the voltage supplied by the rectifier (77).

24. Device according to Claim 1, characterised in that it includes a frequency detector (79), into which an alternating signal is fed, and which emits an output signal at its output (93).

25. Device according to Claim 24, characterised in that the alternating signal is the output signal of the comparator (3).

26. Device according to Claim 24, characterised in that the frequency detector includes a series resonant circuit (86,87), the resonant frequency of which is essentially the same as the base frequency of the clock cycle signal; and that the connection point of the elements (86, 87) of the series resonant circuit is connected to the output (93) of the frequency detector (79).

## Revendications

1. Dispositif pour la comparaison d'une première tension continue (U₁) avec une deuxième tension continue (U₂),
avec un comparateur (3) à deux entrées (9, 11), à la première entrée (11) duquel est appliquée la première tension continue (U₁),
avec un dispositif convertisseur de tension (2) qui comporte une entrée de commande (6) à laquelle est appliqué un signal impulsionnel (8), une entrée de signal (5) à laquelle est appliquée la deuxième tension continue (U₂) et une sortie (7) qui est connectée à la deuxième entrée (9) du comparateur (3) et qui, lorsque les tensions sont appliquées aux entrées (5, 6), délivre une tension (u₇) qui évolue périodiquement entre une valeur d'amplitude supérieure (A₀) et une valeur d'amplitude inférieure (A_{L}), la différence entre les deux valeurs d'amplitude (A₀, A_{L}) étant sensiblement égale à une valeur de différence prédéterminée.

2. Dispositif selon la revendication 1, caractérisé par le fait que le dispositif convertisseur de tension (2) est formé d'un dispositif additionneur dans lequel une tension alternative (8) est ajoutée à une tension dérivée de la deuxième tension continue (U₂).

3. Dispositif selon la revendication 1, caractérisé par le fait que la première tension continue (U₁) présente une valeur de consigne, par le fait qu'une valeur de tension située entre les valeurs d'amplitude supérieure et inférieure (A₀, A_{L}) correspond à la valeur de consigne et par le fait que la valeur de différence prédéterminée correspond à la marge de tolérance admissible pour la première tension continue (U₁).

4. Dispositif selon la revendication 1, caractérisé par le fait que la deuxième tension continue (U₂) présente une valeur de consigne et par le fait qu'une valeur de tension comprise entre les valeurs d'amplitude supérieure et inférieure (A₀, A_{L}) est égale à la première tension continue (U₁) lorsque la deuxième tension continue (U₂) atteint sa valeur de consigne et par le fait que la valeur de différence prédéterminée correspond à la largeur de tolérance admissible de la deuxième tension continue (U₂).

5. Dispositif selon la revendication 1, caractérisé par le fait qu'il est prévu des moyens (34, 35 ; 38, 39) qui, à partir d'une tension d'alimentation (U_{B}), dérivent une tension qui est au moins essentiellement proportionnelle à la tension d'alimentation (U_{B}) ou dont la variation est essentiellement proportionnelle à la variation de la tension d'alimentation (U_{B}) et par le fait que la tension dérivée constitue une des deux tensions continues (U₁, U₂).

6. Dispositif selon la revendication 1, caractérisé par le fait qu'il est prévu des moyens (26, 44) qui, à partir d'une tension d'alimentation (U_{B}), dérivent une tension qui est au moins essentiellement indépendante de la tension d'alimentation (U_{B}) et forme une tension de référence essentiellement fixe qui constitue une des deux tensions continues (U₁, U₂).

7. Dispositif selon la revendication 1, caractérisé par le fait que la tension de référence est indépendante de la tension d'alimentation (U_{B}).

8. Dispositif selon la revendication 1, caractérisé par le fait que le signal impulsionnel (8) est un signal carré.

9. Dispositif selon la revendication 1, caractérisé par le fait qu'au moins une résistance ohmique (34, 43) est montée entre l'entrée de signal (5) et la sortie (7) du dispositif convertisseur de tension (2).

10. Dispositif selon la revendication 1, caractérisé par le fait qu'au moins un élément présentant la caractéristique d'une diode Zener est monté entre l'entrée de signal (5) et la sortie (7) du dispositif convertisseur de tension (2).

11. Dispositif selon la revendication 1, caractérisé par le fait qu'au moins un élément (44, 45) présentant la caractéristique d'une diode Zener est monté entre la sortie (7) du dispositif convertisseur de tension (2) et une masse (13) commune avec le comparateur (3).

12. Dispositif selon la revendication 1, caractérisé par le fait qu'au moins une résistance ohmique (35) avec la caractéristique d'une diode Zener est placée entre la sortie (7) du dispositif convertisseur de tension (2) et une masse (13) commune avec le comparateur (3).

13. Dispositif selon la revendication 1, caractérisé par le fait que le dispositif convertisseur de tension (2) comprend au moins un commutateur électronique (31) à l'aide duquel une tension supplémentaire est appliquée périodiquement à la sortie (7) du dispositif convertisseur de tension (2).

14. Dispositif selon la revendication 1, caractérisé par le fait que le dispositif convertisseur de tension (2) comprend au moins un commutateur électronique (42) à l'aide duquel un dipôle (45) monté en parallèle avec le commutateur électronique (42) est périodiquement court-circuité.

15. Dispositif selon la revendication 1, caractérisé par le fait qu'il comporte un générateur de signaux carrés pour produire le signal impulsionnel (8).

16. Dispositif selon la revendication 1, caractérisé par le fait qu'il comporte un convertisseur de tension (4) connecté à la sortie du comparateur (3).

17. Dispositif selon la revendication 16, caractérisé par le fait que le convertisseur de tension (4) produit une tension (U_{A}) qui représente une tension extérieure au système.

18. Dispositif selon la revendication 17, caractérisé par le fait que la tension extérieure au système est une tension galvaniquement séparée de la tension surveillée (U_{B}).

19. Dispositif selon la revendication 17, caractérisé par le fait que la tension extérieure au système est une tension qui, du point de vue de la valeur et du signe, est supérieure ou inférieure à la tension surveillée (U_{B}).

20. Dispositif selon la revendication 16, caractérisé par le fait que le convertisseur de tension (4) est un multiplicateur de tension formé de condensateurs (53, 56) et de diodes (54, 55).

21. Dispositif selon la revendication 16, caractérisé par le fait que le convertisseur de tension (4) comporte, côté sortie, un transformateur de séparation (73).

22. Dispositif selon la revendication 21, caractérisé par le fait qu'un enroulement de sortie (76) du transformateur de séparation (73) est connecté à un redresseur (77).

23. Dispositif selon la revendication 22, caractérisé par le fait que la tension surveillée (U_{B}) est en série avec la tension délivrée par le redresseur (77).

24. Dispositif selon la revendication 1, caractérisé par le fait qu'il comporte un détecteur de fréquence (79) auquel un signal impulsionnel est envoyé et qui, au niveau de sa sortie (93), délivre un signal de sortie.

25. Dispositif selon la revendication 24, caractérisé par le fait que le signal impulsionnel est le signal de sortie du comparateur (8).

26. Dispositif selon la revendication 24, caractérisé par le fait que le détecteur de fréquence comporte un circuit oscillant série (86, 87) dont la fréquence de résonance correspond sensiblement à la fréquence de base du signal de synchronisation et par le fait que le point de connexion des éléments (86, 87) du circuit oscillant série est connecté à la sortie (93) du détecteur de fréquence (79).
